Europäisches Patentamt

European Patent Office

Office européen des brevets

(19)

(11) Publication number: **0 197 791**
**A2**

(12)

# EUROPEAN PATENT APPLICATION

(21) Application number: **86302595.3**

(22) Date of filing: **08.04.86**

(51) Int. Cl.⁴: **G 01 N 24/02**
**G 01 N 24/04**

(30) Priority: **08.04.85 US 720788**

(43) Date of publication of application:
**15.10.86 Bulletin 86/42**

(84) Designated Contracting States:
**CH DE GB LI**

(71) Applicant: **VARIAN ASSOCIATES, INC.**
**611 Hansen Way**
**Palo Alto, CA 94303(US)**

(72) Inventor: **Smallcombe, Stephen**
**1533 Norman Avenue**
**San Jose California(US)**

(72) Inventor: **Codrington, Robert S.**
**26185 St. Francis Drive**
**Los Altos Hills California(US)**

(74) Representative: **Cline, Roger Ledlie et al,**
**STANLEY, POPPLEWELL, POOLE 57 Lincoln's Inn Fields**
**London WC2A 3LS(GB)**

(54) Coding NMR samples for automated changers.

(57) Analysis samples are presented to an analysis system in respective containers bearing encoded information which is read by optical means and utilized to identify the sample and control the analysis system accordingly.

EP 0 197 791 A2

The present invention is in the field of NMR instrumentation generally and pertains specifically to automated apparatus for presentation of samples to an NMR spectrometer.

Clinical analytical instrumentation in general has developed to provide efficient automated apparatus for unattended presentation of samples to the general instrument. The instrument provides an analytical result, often in the form of a spectrum which may be subject to still further analysis whether by computer or human interpreter.

In high resolution NMR spectroscopy, the sample is typically contained in a glass capillary. The latter is close-fitted to a rotor for insertion into a stator within the spectrometer, an air bearing formed therebetween and spun at a high rate. Prior art spectrometers of this type have been known to employ a light sensitive diode, light source and reflective patch on the rotor to monitor the spinning rate. Such a system is described in US-A- 3,462,677, assigned to the present applicants.

In addition to the high speed rotation of samples, high resolution NMR systems utilize a convenient sample ejection procedure whereby gas flow driving the turbine/air bearing is diverted by valve manipulation to drive the sample and rotor out of the sensitive volume of the spectrometer. Such a system is described in US-A-4,275,350 and 3,512,078

Many automated sample presentation systems are known and practiced for a variety of analytical instruments. The details of such sample changers are not essential for the understanding of the present invention.

The present invention is set out in Claim 1. It may employ an optical detection channel responsive to an associated light source and a reflective coding label affixed to a sample carrier for the purpose of identifying the sample, prescribing the operating parameters of the spectrometer and retaining that information along with the measured spectral data and sample rotation rate in the control processor of the spectrometer.

In another embodiment, the sample insertion or removal is employed to mechanically scan a set of axially displaced reflective coding data annulii by a fixed photodiode and associated light source to automatically register identifying data and test instructions during the insertion of the sample tube or identifying the sample tube upon removal from the spectrometer.

FIG. 1 is a sketch of the operating context of an example of the invention.

FIG. 2 is a section of a portion of a probe of the present invention.

FIG. 3 is a top view of the apparatus of FIG. 1.

FIG. 4 is a schematic block diagram of the logic circuit responsive to the optical detectors of FIG. 1.

FIG. 5 is a circuit timing diagram for the circuit of FIG. 3.

FIG. 6 shows apparatus responsive to a linear insertion/or ejection of a sample tube.

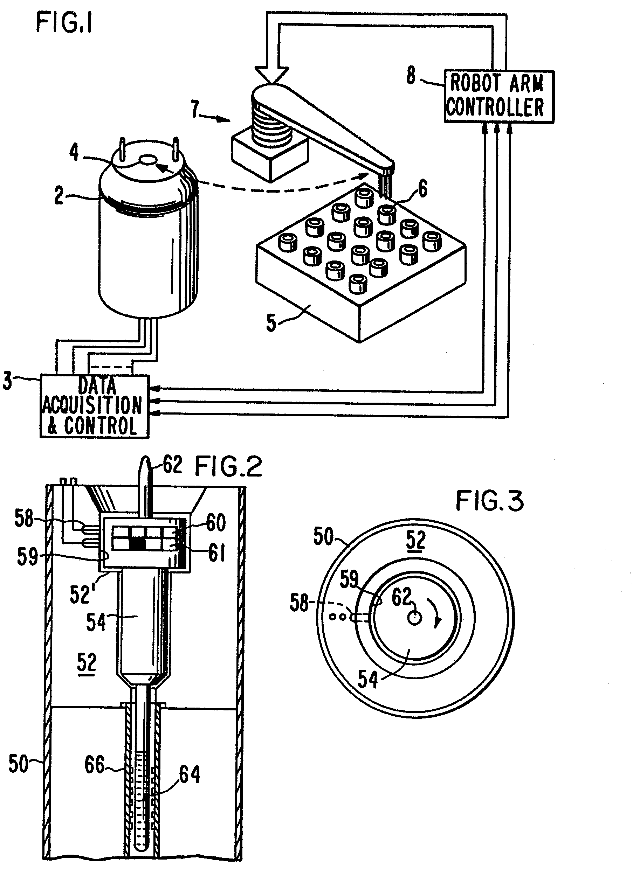

A suitable application of the present invention is indicated in FIG. 1 where a superconducting magnet cryostat 2 and data acquisition/control system 3 comprise an NMR spectrometer. The cryostat contains a superconducting magnet and a bore 4 in which there is disposed probe structure for excitation of a sample presented therein and measurement of the resonance signal. A sample tray 5 contains a number of samples 6 for measurement, each sample contained as discussed below. A robot arm apparatus 7 and controller 8 communicate with the data acquisition/controller apparatus 3 to actuate the robot arm. Typically, the robot arm is controllable to extend horizontally, lift a sample vertically, rotate over the bore 4 of the spectrometer, lower vertically to deposit the sample, recover the sample and repeat the cycle.

The present invention need not include automated sample presentation apparatus as indicated above. However, the purposes and useful ends served by the invention are most frequently encountered in the context of batch processing of a number of samples.

Turning now to FIGS. 2 and 3, there is shown the relevant mechanical features of the probe. A probe body 50 contains stator 52 in which rotor 54 levitates and rotates under the impelling force of a high pressure gas issuing from jets 56. A step 52' and the stator housing provides an air bearing surface over which the rotor levitates. The stator also contains optical detectors 58 and 59 which are responsive to reflected light from coded reflecting labels strips 60 and 61. A light source and optical detector are constructed as a unit comprising an LED and associated photodiode. The photodiode is arranged to be especially responsive to the illumination from the associated LED. The sample 62 is fit to the rotor and the sample 64 is surrounded by coil 66 employed to excite and detect nuclear resonance in the sample. Multiple strips of coding label and respective detectors provide a clock code from one optical detection channel and an information code from another strip forming a second optical channel.

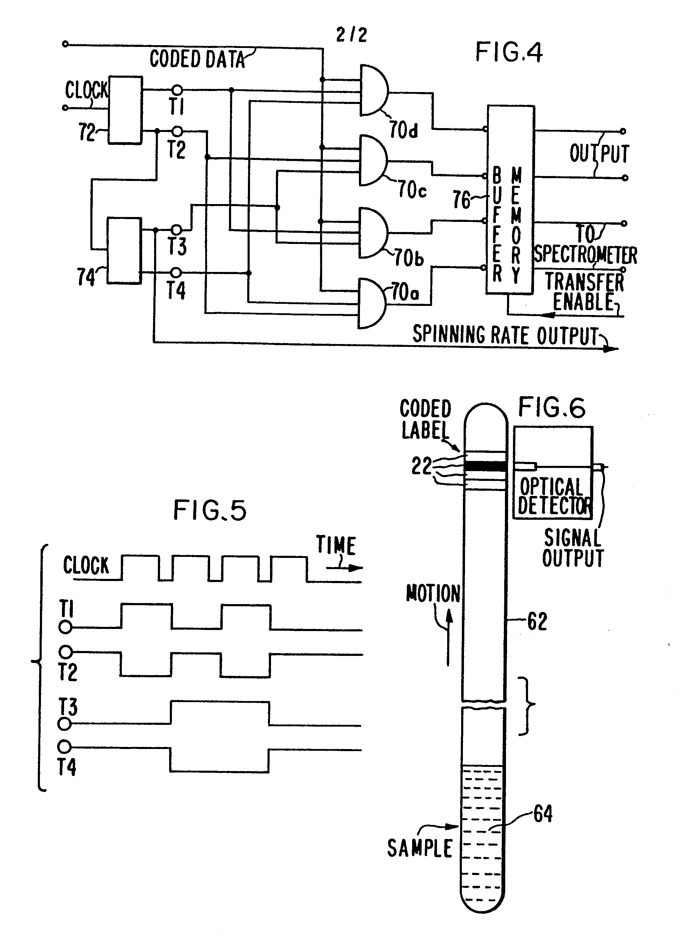

A simple circuit embodiment is shown at FIG. 4 for four-bit label data code. Coded label data from detector 59 are presented in parallel to logical AND gates $70_a$, $70_b$, $70_c$ and $70_d$. The clock channel detector 58 drives pulse forming elements 72 and 74, e.g., one-shots. Concurrent pulses of opposite polarity are derived from the pulse former 72 and the propagation delayed output of pulse former 72 drives pulse forming element 74 to provide another two opposite polarity double length signals. These pulses, respectively labeled $72_a$, $72_b$, $74_c$, and $74_d$ are displayed together with the clock pulse in FIG. 5. A logical combination of pairs of these four signals function to gate the corresponding time serialized bits of the label coded data to place four bits into the latch 76. A strobe pulse from the spectrometer processor transfers the four bit content of the latch to the processor for a configuration of the measurement and/or identification of the sample presented for analysis. A separate clock output 78 is taken from one of the single length clock outputs of one-shot 72 to permit monitoring of the rotation rate.

In FIG. 6 there is shown an embodiment for which labeled data is axially affixed to the sample tube 8. Instead of the rotary scan of azimuthally encoded information, a set of reflective rings 82 encode label data in an axial sense. Insertion of the sample tube in the spectrometer gates the optical detector to read the encoded information in straightforward manner. Where labeling information is all that is required and test parameters are conveyed to the apparatus by other means, the removal of the sample tube provides the axial motion relied upon to scan the label data past the fixed optical detector.

Since many changes can be made in the above construction and many apparently widely differing embodiments of this invention can be made without departing from the scope thereof, it is intended that all matter contained in the above description and shown in the accompanying drawings shall be interpreted as illustrative and not in a limiting sense.

## Claims

1. A gyromagnetic analysis apparatus including a control processor for analyzing signals and controlling the operations of the apparatus, comprising

apparatus for the excitation and detection of gyromagnetic resonance of a sample,

sample handling apparatus comprising a sample container supporting optically encoded means on the outer periphery of said container for communicating information respecting the content of said sample container, a light source and optical detector, means to establish relative motion between said sample container and said optical detector, said optical detector, light source and optically encoded information adapted to transfer information from said optical encoding means through said optical detector to said processor.

2. The gyromagnetic analysis apparatus of claim 1 wherein said relative motion means comprises rotor means affixed to said sample container, gas impelling means for causing rotation of said rotor and said optical encoding means comprises discrete reflective means distributed about the periphery of said rotor means whereby said optically encoded information is developed in serial synchronization with said rotation.

3. The gyromagnetic analysis apparatus of claim 1 wherein said sample container has an axial length, said sample handling apparatus is accessible to receive said sample container along an axis substantially congruent to said sample container axis, and said optical encoding means comprises discrete reflective means distributed axially along the said sample tube whereby said relative motion is accomplished by translatory motion of said container received along the sample handling apparatus axis.

4. The gyromagnetic analysis apparatus of claim 2 wherein said light source illuminates a discrete portion of said optical encoding means and said optical detector is disposed to respond to the reflection of light from said encoding means.

0197791

FIG.1

1/2

8 ROBOT ARM CONTROLLER

7

4

2

6

5

3 DATA ACQUISITION & CONTROL

62 FIG.2

58
59
60
61
52'
54
52
50
66
64

FIG.3

50
52
59
62
58
54

2/2

CODED DATA

CLOCK

T1

72

T2

T3

74

T4

70d

70c

76

70b

70a

FIG.4

BUFFER MEMORY

OUTPUT

TO SPECTROMETER

TRANSFER ENABLE

SPINNING RATE OUTPUT

FIG.5

CLOCK

TIME

T1

T2

T3

T4

FIG.6

CODED LABEL

22

OPTICAL DETECTOR

SIGNAL OUTPUT

MOTION

62

SAMPLE

64